# EUROPÄISCHE PATENTSCHRIFT

(11) **EP 2 574 407 B1**
(45) Veröffentlichungstag und Bekanntmachung des Hinweises auf die Patenterteilung: **02.09.2015**
(21) Anmeldenummer: 12075114.4
(22) Anmeldetag: 27.09.2012
(51) Int. Cl.: B05D 1/36, G03F 7/09, H01L 21/768, G03F 7/16, H01L 23/367, B05D 1/00, B05D 3/04, B05D 1/38

(54) **Verfahren zum Herstellen einer Beschichtung eines Substrats**
Method for producing a coating of a substrate
Procédé de fabrication d'un revêtement d'un substrat

(30) Priorität: 29.09.2011 DE 102011115121
(43) Veröffentlichungstag der Anmeldung: 03.04.2013
(73) Patentinhaber: Fraunhofer-Gesellschaft zur Förderung der angewandten Forschung e.V., 80686 München (DE)
(72) Erfinder: Wilke, Martin, 10715 Berlin (DE); Töpper, Michael, 13507 Berlin (DE)
(74) Vertreter: Pfenning, Meinig & Partner GbR

(56) Entgegenhaltungen:
- EP-A1- 1 315 045
- EP-A1- 1 586 945
- WO-A1-2011/156330
- US-A1- 2011 136 338

## Beschreibung

Die Erfindung betrifft ein Verfahren zum Herstellen einer Beschichtung einer Oberfläche eines mindestens eine Vertiefung aufweisenden Substrats mit einem Beschichtungsmaterial.

Aus den zahlreichen Anwendungsgebieten der Beschichtungstechnologie, wie beispielsweise der Halbleitertechnik, der Mikromechanik oder anderen Bereichen der Mikrosystemtechnologie, sind Verfahren zur Beschichtung verschiedener Substrate bekannt. Zu den größten Schwierigkeiten bei der Herstellung dünner Beschichtungen zählen die Erzeugung gleichmäßiger Schichtdicken sowie die Einschränkungen bezüglich der verwendbaren Beschichtungsmaterialien. Als besonders problematisch erweist sich die Beschichtung von Substraten mit Oberflächentopografien oder Oberflächenstrukturen, wie beispielsweise auf der Substratoberfläche aufgetragene Leiterbahnen oder in das Substrat eingearbeitete Öffnungen, beispielsweise für Durchkontaktierungen, wie etwa Through Silicon Vias ("TSV"), thermische Vias, beispielsweise für die Abführung von Verlustleistungswärme von dem Substrat, Wärmespreizer beispielsweise für die elektrisch isolierte Anordnung von Laserdioden auf einem elektrisch leitfähigen Substrat, oder in die Substratoberfläche eingearbeitete Mikrokanäle.

Beispielsweise besteht ein wesentlicher Nachteil der sogenannten Schleuderbeschichtung oder auch Rotationsbeschichtung ("Spin-Coating") darin, dass die Rotation des Substrats zwar zu einer gleichmäßigen dünnen Beschichtung führen kann, strukturierte Substratoberflächen aber oft nicht zufriedenstellend gleichmäßig beschichtet werden können, da sich das Beschichtungsmaterial meistens in tiefer gelegenen Strukturen auf der Substratoberfläche ansammelt. Dies hat zur Folge, dass tieferliegende Bereiche der Substratoberfläche dann mit einer dickeren Schicht beschichtet sind als weiter oben liegende Bereich.

Bei der Lamination muss das Beschichtungsmaterial als Film oder als Folie vorliegen, wodurch sich starke Einschränkungen an das Beschichtungsmaterial sowie an die beschichtbaren Topografien ergeben. Bei dem so genannten Vorhanggießen wiederum können häufig ebenfalls nur relativ ungleichmäßige Schichtdickenverteilungen erzielt werden. Das Gleiche gilt für das so genannte Tauchbeschichten ("Dip-Coating") sowie für die Sprühbeschichtung ("Spray-Coating"). Das letztgenannte Verfahren hat außerdem den Nachteil langer Prozesszeiten, da häufig Mehrfachbeschichtungen notwendig sind, und ist häufig aufgrund hoher Investitionskosten für entsprechende Anlagen häufig nicht rentabel. Bei der elektrophoretischen Abscheidung muss das Beschichtungsmaterial in Form von Mizellen vorliegen, wodurch sich starke Einschränkungen bezüglich des Beschichtungsmaterials wie auch bezüglich des Substrats ergeben. Letzteres muss dann nämlich eine elektrisch leitfähige Oberfläche besitzen.

In den Druckschriften EP 1 315 045 A1 und EP 1 586 945 A1 wird beschrieben, dass für eine lithografische Bearbeitung einer Substratoberfläche Vertiefungen in der Substratoberfläche zunächst mit einer flüssigen Ausgleichsschicht ausgefüllt werden. Anschließend wird auf die Ausgleichsschicht ein Photolack aufgetragen. In der nachveröffentlichten Druckschrift WO 2011/156330 A1 wird ein Verfahren beschrieben, bei dem auf eine strukturierte Substratoberfläche eine erste flüssige Schicht aufgebracht wird, mit der Vertiefungen, wie beispielsweise VIAs, ausgefüllt werden. Auf diese erste Schicht wird eine zweite Schicht einer wässrigen Dispersion mit kolloidalen Partikeln aufgebracht, wobei die Partikel durch die erste Schicht in die Vertiefungen transportiert werden. Anschließend wird die erste Schicht und die zweite Schicht entfernt, wodurch sich eine Beschichtung der Substratoberfläche mit den Partikeln ausbildet.

Es ist daher die Aufgabe der hier vorgeschlagenen Erfindung, ein Verfahren zum Beschichten von Substraten vorzuschlagen, das die Herstellung möglichst gleichmäßiger Beschichtungen ermöglicht und auch für die

Beschichtung von Substraten mit strukturierten Oberflächen geeignet ist, welche also mindestens eine Vertiefung aufweisen. Außerdem soll das Verfahren sich für eine möglichst große Anzahl verschiedener Beschichtungsmaterialien und Materialien des Substrats eignen.

Diese Aufgabe wird gelöst durch das Verfahren gemäß dem Hauptanspruch. Weiterentwicklungen und spezielle Ausführungsformen der Erfindung sind Gegenstände der abhängigen Ansprüche.

Bei dem hier vorgeschlagenen Verfahren wird also zum Herstellen einer Beschichtung einer Oberfläche eines mindestens eine Vertiefung aufweisenden Substrats mit einem Beschichtungsmaterial das Beschichtungsmaterial auf das Substrat aufgetragen. Dieses Verfahren beinhaltet die folgenden Schritte:
- Zunächst wird auf die Oberfläche des Substrats eine flüssige Hilfssubstanz aufgetragen und die mindestens eine Vertiefung in der Oberfläche des Substrats mit der flüssigen Hilfssubstanz ausgefüllt.
- Anschließend wird das Beschichtungsmaterial auf die Hilfssubstanz, die auf die Oberfläche des Substrats aufgetragen worden ist und die dort in der Regel einen dünnen, flüssigen Film ausgebildet hat, aufgetragen.

- Das Beschichtungsmaterial dringt zumindest teilweise in die Hilfssubstanz ein, beispielsweise durch einen Lösungsprozess, und wird durch Diffusion des Beschichtungsmaterials in der flüssigen Hilfssubstanz zumindest teilweise in die mindestens eine mit der flüssigen Hilfssubstanz ausgefüllte Vertiefung in der Oberfläche des Substrats transportiert.
- Anschließend wird die Hilfssubstanz von der Oberfläche des Substrats entfernt, wobei das Beschichtungsmaterial jedoch zumindest teilweise auf der Oberfläche des Substrats zurückbleibt und die Beschichtung der Oberfläche einschließlich der mindestens einen Vertiefung in der Oberfläche mit dem Beschichtungsmaterial ausbildet. Das Entfernen der Hilfssubstanz von der Oberfläche des Substrats kann, wie weiter unten erläutert wird, durch Verdampfen bzw. Verdunsten der Hilfssubstanz und/oder durch Trocknen erfolgen. Es kann ferner vorgesehen sein, dass vor einer vollständigen Entfernung der Hilfssubstanz die Hilfssubstanz zunächst teilweise, insbesondere bis auf Anteile der Hilfssubstanz innerhalb der mindestens einen Vertiefung, von der Oberfläche des Substrats entfernt wird, beispielsweise durch Abschleudern der Hilfssubstanz. Durch das vollständige Entfernen der Hilfssubstanz von dem Substrat wird die Hilfssubstanz von dem Beschichtungsmaterial gleichzeitig getrennt.

Bei dem hier vorgeschlagenen Verfahren hat die flüssige Hilfssubstanz die Funktion, die zu beschichtende Oberfläche des Substrats möglichst vollständig zu benetzen und dabei Oberflächenstrukturen und/oder Oberflächentopographien, wie insbesondere die genannte mindestens eine Vertiefung in der Oberfläche, möglichst vollständig auszufüllen und mit einer flüssigen Schicht des Hilfssubstanz möglichst vollständig abzudecken. Auf diese Weise kann das Beschichtungsmaterial anschließend durch Diffusionsbewegungen (beispielsweise auf der Ebene von Atomen, Molekülen oder Partikeln des Beschichtungsmaterials) innerhalb dieser Schicht der Hilfssubstanz in die genannten Oberflächenstrukturen und insbesondere in die mindestens eine Vertiefung in der Oberfläche des Substrats eindringen. Es ist mit diesem Verfahren möglich, nur einen Teil der Oberfläche mit der Hilfsflüssigkeit zu bedecken, um nur diesen Teil zu beschichten. Es ist aber auch möglich, die gesamte Oberfläche des Substrats zu beschichten, wobei dann die gesamte Oberfläche des Substrats mit der Hilfsflüssigkeit bedeckt wird.

Somit erlaubt es das vorgeschlagene Verfahren, nach einer anschließenden Entfernung der Hilfssubstanz und ggf. eines Lösungsmittels, in dem das Beschichtungsmaterial gelöst ist, selbst solche Oberflächen mit einer sehr gleichmäßigen und unterbrechungsfreien Beschichtung zu versehen, die sehr kleine und/oder scharfkantige Oberflächenstrukturen aufweisen. Die genannten Oberflächenstrukturen, welche beispielsweise durch die genannte mindestens eine Vertiefung gegeben sein können, können eine Länge, eine Breite und/oder einen Durchmesser von weniger als 150 Mikrometern oder sogar von weniger als 50 Mikrometern aufweisen und dabei gleichzeitig eine Tiefe (gemessen von einem Boden der Vertiefung bzw. Oberflächenstruktur bis zu einem oberen Rand der Vertiefung bzw. Oberflächenstruktur) von mehr als 200 Mikrometern oder sogar von mehr als 500 Mikrometern aufweisen. Es ist auch möglich, dass alle oder zumindest manche dieser Oberflächenstrukturen, wie etwa die mindestens eine Vertiefung, eine Länge, eine Breite und/oder einen Durchmesser von weniger als 20 Mikrometern oder sogar von weniger als 10 Mikrometern aufweisen und dabei gleichzeitig eine Tiefe von mehr als 100 Mikrometern oder sogar von mehr als 200 Mikrometern aufweisen. Bei dem genannten Durchmesser kann es sich auch um einen sogenannten minimalen Durchmesser der Oberflächenstruktur bzw. Vertiefung handeln, welcher unten genauer definiert wird.

Insbesondere kann auch die mindestens eine Vertiefung der Oberfläche des Substrats geleichmäßig beschichtet werden, so dass sogar auch ein möglicherweise scharfkantiger Rand der mindestens einen Vertiefung mit einer ausreichenden Schichtdicke beschichtet wird. Gerade die Beschichtung derartiger oberer Ränder von Vertiefungen und insgesamt alle Oberflächenbereiche des Substrats, die sehr starke Krümmungen aufweisen können herkömmlichen Beschichtungsverfahren in der Regel nicht gleichmäßig beschichtet werden.

So kann nun Beispielsweise die mindestens eine Vertiefung der Oberfläche einen minimalen Durchmesser von weniger als 100 Mikrometer, weniger als 20 Mikrometer oder sogar weniger als 10 Mikrometer aufweisen, ohne dass eine gleichmäßige Beschichtung der Oberfläche des Substrats im Bereich dieser Vertiefung gefährdet wäre.

Dabei sei ein (richtungsabhängiger) Durchmesser einer gegebenen Vertiefung durch den Abstand zweier einander gegenüberliegender Punkte auf einem oberen Rand dieser Vertiefung definiert. Dementsprechend bezeichne der minimale Durchmesser einer Vertiefung den kleinsten aller (richtungsabhängigen) Durchmesser dieser Vertiefung.

Es ist auch möglich, Oberflächen mit sehr tiefen Vertiefungen zu beschichten, die gleichzeitig, wie oben beschrieben, einen sehr geringen minimalen Durchmesser aufweisen, die also zumindest in einer Richtung im Vergleich zu ihrer Tiefe sehr schmal sind. Dabei ist die Tiefe einer Vertiefung definiert als der Abstand zwischen einem oberen Rand der Vertiefung und einem Boden der Vertiefung. So kann die Tiefe der mindestens einen Vertiefung beispielsweise mehr als 20 µm betragen oder sogar mehr als 200 µm oder 500 µm. So ist es beispielsweise möglich, dass die Tiefe der mindestens einen Vertiefung mindestens zehnmal so groß ist wie der minimale Durchmesser der Vertiefung. Es ist auch möglich, dass die Tiefe der Vertiefung mindestens zwanzigmal so groß wie der minimale Durchmesser der Vertiefung.

Die oben genannten Oberflächenstrukturen oder Topographien der Oberfläche des Substrats, also insbesondere die mindestens eine Vertiefung in der Oberfläche des Substrats, können beispielsweise gegeben sein durch eine oder mehrere Durchtrittsöffnung(en) durch das Substrat hindurch, insbesondere zur Herstellung einer Durchkontaktierung durch das Substrat, wie beispielsweise von Through Silicon Vias (TSV). Es ist außerdem möglich, dass die genannten Oberflächenstrukturen bzw. Topographien der Oberflächen einen oder mehrere in das Substrat eingearbeiteten mikrofluidischen Kanal/Kanäle, thermische Vias und/oder Wärmespreizer umfassen.

Bei der Beschichtung der Oberfläche des Substrats kann es sich beispielsweise um eine elektrische Isolierung der Oberfläche des Substrats handeln. Aufgrund der mit diesem Verfahren erzielbaren gleichmäßigen Schichtdicken der Beschichtung, können vorteilhafterweise Kurzschlüsse auch in Bereichen starker Krümmungen der Oberfläche, wie etwa in Randbereichen der Vertiefungen, etwa von Durchtrittsöffnungen, Durchkontaktierungen und TSVs, sicher vermieden werden.

Für das vorgeschlagene Verfahren wird vorzugsweise eine Hilfssubstanz verwendet, welche die Oberfläche des Substrats besonders gut benetzen kann und die genannten Oberflächenstrukturen des Substrats möglichst schnell und vollständig abdecken und ausfüllen kann. Eine solche Hilfssubstanz zeichnet sich typischerweise durch eine besonders geringe Oberflächenspannung und/oder eine besonders geringe Viskosität aus. Vorzugsweise ist das Material der Hilfssubstanz außerdem so gewählt, dass an den Grenzflächen zwischen der auf das Substrat aufgebrachten Hilfssubstanz und der Oberfläche des Substrats eine möglichst große Grenzflächenenergie frei wird.

Um eine möglichst gute Benetzung der Substratoberfläche und Ausfüllung der mindestens einen Vertiefung in der Substratoberfläche zu gewährleisten, hat die Hilfssubstanz also vorzugsweise eine möglichst kleine dynamische Viskosität η. Vorzugsweise hat die dynamische Viskosität η einen Wert von maximal 5,0 mPa·s, besonders bevorzugt beträgt die Viskosität η weniger als 3 mPa·s oder sogar weniger als 1 mPa·s. Diese Werte der dynamischen Viskosität beziehen sich jeweils auf die Temperatur der Hilfssubstanz beim Auftragen der Hilfssubstanz auf die Oberfläche des Substrats. Es kann daher auch vorgesehen sein, die Temperatur des Substrats und/oder der Hilfssubstanz zu erhöhen, um die Viskosität der Hilfssubstanz zu verringern, beispielsweise in einem Bereich von 20°C bis 200°C.

Die Oberflächenspannung der Hilfssubstanz beträgt vorzugsweise weniger als 40 mN/m, vorzugsweise weniger als 30 mN/m.

Als mögliche Hilfssubstanzen kommen beispielsweise in Frage Ethyllactat (Milchsäureester) oder PGMEA (Propylenglykolmonomethylacetat).

Typischerweise hat das Beschichtungsmaterial, das vorzugsweise in Form einer Lösung vorliegt, also in einem Lösungsmittel gelöst ist, eine wesentlich höhere dynamische Viskosität. Diese kann um einen Faktor von 10-100 größer sein als die der oben genannten bevorzugten Werte der dynamischen Viskosität der Hilfssubstanz, so dass sich hieraus in der Regel wesentlich schlechtere Benetzungseigenschaften des (gelösten) Beschichtungsmaterial ergibt im Vergleich zur Hilfssubstanz, in der kein Beschichtungsmaterial gelöst ist. Die Hilfssubstanz hat daher, wie oben bereits beschrieben, die Funktion, die zu beschichtende Oberfläche des Substrats vollständig und lückenlos zu benetzen und anschließend den Transport des Beschichtungsmaterials in die (von der Hilfssubstanz ausgefüllten) Oberflächenstrukturen und Vertiefungen mittels Diffusion zu ermöglichen. Im Fall, dass das Beschichtungsmaterial vor dem Auftragen auf die Hilfssubstanz auf dem Substrat in einem Lösungsmittel gelöst ist, können das Lösungsmittel und die Hilfssubstanz durch identische Materialien gegeben sein. Es ist möglich, dass sich Hilfssubstanz und Lösungsmittel nach Auftragen des Lösungsmittels auf die Hilfssubstanz miteinander vermischen.

Als Beschichtungsmaterial kommen prinzipiell alle Materialien in Frage, die in die verwendete Hilfssubstanz übergehen, etwa durch Lösen, und diffundieren können. So kann das Beschichtungsmaterial beispielsweise Polymere, Prepolymere, Monomere und/oder Fotolacke beinhalten. Es sind auch Kombinationen verschiedener Materialien möglich sind. In Frage kommen insbesondere Polyimide (PI), Benzocyklobutan (BCB) Polybenzoxazole (PBO), Epoxidharze, Acrylate, Fluoropolymere, Silicone, Silane, organisch modifizierte Silane und andere Polymere, die sich zur Herstellung dünner Beschichtungen eignen. Es können auch Photoresiste verwendet werden, die auf einem Phenolharz wie Novolak basieren und die z.B. in PGMEA oder Ethyllactat als Lösungsmittel verdünnt bzw. gelöst sind. Spezielle weitere Beispiele für das Beschichtungsmaterial sind "AZ-Lack" (AZ9260) des Herstellers AZ Electronic Materials, der typischerweise in PGMEA verdünnt ausgeliefert wird, "ELPAC 5100" des Herstellers JSR Corp., welches ebenfalls auf einem Phenolharz basiert und in Ethyllactat verdünnt ist. Weitere Beispiele für das Beschichtungsmaterial sind Polymere auf BCB-Basis (genauer: Divinylsiloxan-bis-Bezocyclobutan), welche z.B. mit Mesitylen verdünnt sein können sowie Polyimide, die z.B. in NMP (N-Methyl-2-pyrrolidon) oder Cyclopentanon gelöst sein können.

Das Beschichtungsmaterial wird typischerweise in Abhängigkeit von der zu erzielenden Funktion der Beschichtung ausgewählt. Mögliche Funktionen der Beschichtung sind beispielsweise die eines Permanentdielektrikums, die Funktion einer Passivierung des Substrats oder die Funktion eines Fotolacks für galvanische Prozesse oder Ätzprozesse. Das Beschichtungsmaterial kann auch mittels nanotechnologischer Verfahren modifiziert sein, z.B. hinsichtlich seiner magnetischen, elektrischen oder optischen Eigenschaften. Das Beschichtungsmaterial kann außerdem auf das Material des Substrats abgestimmt sein.

Als Material des Substrats kommen insbesondere dotiertes oder nichtdotiertes Silizium, Gläser, Keramikwerkstoffe oder Kunststoffe in Frage. Die Form des Substrats kann scheiben- oder plattenförmig sein. Insbesondere kann das Substrat durch einen Wafer oder eine Leiterplatte gegeben sein.

Die Form und das Material des Substrats sowie das Beschichtungsmaterial sowie die Dicke der Beschichtung des Substrats ergeben sich durch die jeweilige Anwendung des Substrats, welche beispielsweise auf dem Gebiet der Halbleitertechnik, der Mikromechanik, der Sensorik, der Mikrofluidik, der LED-Technik oder der Medizintechnik liegen kann. Typische Schichtdicken, die mit dem vorgeschlagenen Verfahren hergestellt werden können, liegen im Bereich von 1 µm bis mehrere 10 µm. Es sind auch Schichtdicken im Submikrometerbereich erzielbar. Das vorgeschlagene Verfahren erlaubt die Herstellung beliebig dünner, durchgängiger Beschichtungen. Denkbar sind beispielsweise Beschichtungen, die nur aus einer einzigen Einzellage von Molekülen des Beschichtungsmaterials bestehen, in der die Moleküle also nicht übereinander sondern nur nebeneinander auf der Substratoberfläche angeordnet sind. Entsprechend sind auch Beschichtungen möglich, in denen maximal 10 Moleküle oder maximal 100 Moleküle des Beschichtungsmaterials übereinander angeordnet sind.

Ein besonderer Vorteil des hier vorgeschlagenen Verfahrens ist es also, dass eine sehr große Anzahl verschiedener Materialien für das Substrat wie auch für das Beschichtungsmaterial verwendet werden können und somit weitaus weniger Einschränkungen bezüglich der möglichen Anwendungen bestehen als bei den meisten der eingangs genannten herkömmlichen Beschichtungsverfahren. Es können beispielsweise alle Beschichtungsmaterialien verwendet werden, die auch für das "Spin-Coating" und das "Spray-Coating" verwendet werden können. Insbesondere können für das vorgeschlagene Verfahren herkömmliche Vorrichtungen für das Rotationsbeschichten ("Spin-Coating") und das Sprühbeschichten verwendet werden, wie weiter unten beschrieben wird. In diesem Fall ist in der Regel nur eine entsprechende Modifikation der Prozessführung notwendig, aber keine weiteren Anpassungen an der Vorrichtung (dem "Spin-Coater") oder sonstige Investitionen.

In einer Ausführungsform des Verfahrens wird die flüssige Hilfssubstanz durch Übergießen, Spritzen, Sprühen, Kondensation oder Rakeln auf die Oberfläche des Substrats aufgetragen. Im Fall, das das Beschichtungsmaterial in flüssiger Form vorliegt oder in einem Lösungsmittel gelöst ist, wie oben beschrieben, kann das Beschichtungsmaterial ebenfalls durch Übergießen, Spritzen, Sprühen, Kondensation oder Rakeln auf die flüssige Hilfssubstanz auf dem Substrat aufgetragen werden. Es ist möglich, das Substrat beim Auftragen der Hilfssubstanz und/oder beim Auftragen des Beschichtungsmaterials zu rotieren, etwa unter Verwendung eines Drehtellers ("Chuck") einer Vorrichtung zur Durchführung von Rotationsbeschichtungen ("Spin-Coater"), um die Hilfssubstanz und/oder das Beschichtungsmaterial auf der Oberfläche des Substrats bzw. auf der Hilfssubstanz zu vergleichmäßigen.

So ist es beispielsweise möglich, dass Beschichtungsmaterial, das in flüssiger Form vorliegt oder in einem Lösungsmittel gelöst ist, von einem Mittelpunkt des Substrats ausgehend schneckenförmig auf der Hilfssubstanz aufzutragen und anschließend durch Vergrößern einer Rotationsfrequenz des Substrats auf der Hilfssubstanz zu vergleichmäßigen. Anschließend können, nachdem das Beschichtungsmaterial hinreichend stark in die Hilfssubstanz hinein diffundiert ist, durch Vergrößern der Rotationsfrequenz die Hilfssubstanz und das Lösungsmittel bis zu einem gewünschten Grad on der Oberfläche des Substrats durch Abschleudern entfernt werden. Es kann beispielsweise vorgesehen sein, dass die Hilfssubstanz und gegebenenfalls auch das Lösungsmittel des Beschichtungsmaterials durch Abschleudern bis auf Anteile der Hilfssubstanz und gegebenenfalls des Lösungsmittels innerhalb der mindestens einen Vertiefung von der Oberfläche des Substrats entfernt wird bzw. werden. In einem nachfolgenden Schritt kann vorgesehen sein, dass verbleibende Anteile der Hilfssubstanz und gegebenenfalls des Lösungsmittels durch Trocknen und/oder Verdampfen von der Oberfläche des Substrats teilweise oder vollständig entfernt werden.

In einer Ausführungsform des Verfahrens wird die Hilfssubstanz und gegebenenfalls auch das Lösungsmittel, in dem das Beschichtungsmaterial gelöst ist, Trocknen und/oder Verdampfen von der Oberfläche des Substrats vollständig oder zumindest teilweise entfernt. Es kann vorgesehen sein, das eine Umgebungstemperatur des Substrats und/oder eine Temperatur das Substrat zu erhöhen, beispielsweise mittels einer Mikrowellenstrahlung des Substrats, beispielsweise in einem Temperaturbereich zwischen 60°C und 150°C. Es jedoch bei der Verwendung von wärmeempfindlichen Materialien die Überschreitung entsprechender Grenztemperaturen zu vermeiden. Beispielsweise können photoempfindliche Materialien durch Überhitzung ihre Photoempfindlichkeit verlieren, oftmals bereits ab Temperaturen von 150°C. Es kann auch vorgesehen sein, einen Umgebungsdruck des Substrats abzusenken, um eine Entfernung der Hilfssubstanz und/oder des Lösungsmittels, etwa durch Trocknen oder Verdampfen, zu beschleunigen, beispielsweise durch Anlegen eines Grobvakuums.

Beim Entfernen der Hilfssubstanz und gegebenenfalls auch des Lösungsmittels des Beschichtungsmaterials ist es wichtig, dass zumindest ein Teil des Beschichtungsmaterials auf der Oberfläche des Substrats zurückbleibt. Dieser zurückbleibende Teil des Beschichtungsmaterials bildet die Beschichtung der Oberfläche des Substrats aus. Wird die Hilfssubstanz und gegebenenfalls auch das Lösungsmittels des Beschichtungsmaterials zunächst in einem ersten Schritt teilweise entfernt, beispielsweise mechanisch, etwa durch Abschleudern wie oben beschrieben, kann erreicht werden, dass diese Flüssigkeiten noch in der mindestens einen Vertiefung auf der Oberfläche des Substrats zurückbleibt und von anderen Bereichen der Oberfläche vollständig oder bis auf geringe Reste entfernt wird. Durch anschließendes vollständiges Entfernen der Hilfssubstanz und gegebenenfalls auch des Lösungsmittels, beispielsweise durch Trocknen oder Verdampfen, kann auf diese Weise eine selektive Beschichtung der Oberfläche des Substrats innerhalb der mindestens einen Vertiefung erreicht werden, wobei andere Bereich der Oberfläche nicht oder nur sehr dünn beschichtet werden.

In einer Weiterentwicklung des Verfahrens werden in einem weiteren Schritt, vorzugsweise bevor das Beschichtungsmaterial aufgetragen wird, Gasblasen, die zwischen der flüssigen Hilfssubstanz und der Oberfläche des Substrats eingeschlossen sind, entfernt. Dabei können insbesondere auch solche Gasblasen entfernt werden, die sich innerhalb der mindestens einen Vertiefung der Oberfläche befinden. Durch das Entfernen der Gasblasen wird eine unterbrechungsfreie Beschichtung der Substratoberfläche, insbesondere innerhalb der mindestens einen Vertiefung, gewährleistet. Prinzipiell ist es aber auch möglich, die Gasblasen innerhalb der Vertiefungen zu belassen, um eine vollständige Beschichtung der Oberfläche des Substrats innerhalb der mindestens einen Vertiefung zu vermeiden, insbesondere um die Beschichtung eines Bodens der mindestens einen Vertiefung zu verhindern oder auszusparen. Es kann so beispielsweise erreicht werden, dass zwar Innenwänden und ein oberer Rand der mindestens einen Vertiefung mit dem Beschichtungsmaterial beschichtet werden, aber ein Boden der Vertiefung oder besonders tief liegende Anteile der Innenwand der mindestens einen Vertiefung, welche von der Gasblase abgedeckt sind, nicht beschichtet werden, da in diese Bereiche das Beschichtungsmaterial nicht durch Diffusion vordringen kann.

Um die genannten Glasblasen zwischen der Oberfläche und der Hilfssubstanz zu entfernen, kann vorgesehen sein, einen Umgebungsdruck einer an die Hilfssubstanz angrenzenden Umgebung des Substrats anzuheben oder abzusenken und durch dieses Anheben und/oder Absenken des genannten Umgebungsdrucks eine Bewegung der Gasblasen von der Oberfläche des Substrats weg und durch die flüssige Hilfssubstanz hindurch auszulösen. Vorzugsweise werden das Anheben und/oder das Absenken des Umgebungsdrucks noch vor dem Auftragen des Beschichtungsmaterials auf die Hilfssubstanz durchgeführt, um eine homogene Verteilung des Beschichtungsmaterials in der Hilfssubstanz zu erzielen bzw. um diese homogene Verteilung durch die Bewegung der Gasblasen durch die Hilfssubstanz hindurch nicht zu stören.

Vorzugsweise wird der Umgebungsdruck zum Entfernen der Gasblasen nur kurzzeitig abgesenkt und möglichst unmittelbar nach Entfernen der Gasblasen wieder angehoben. Beispielsweise ist es möglich, dass der Umgebungsdruck um mindestens 0,5 bar abgesenkt bzw. angehoben wird. Vorzugsweise wird der Druck aber um mindestens 1 bar abgesenkt und/oder angehoben, um eine möglichst sichere Entfernung der Gasblasen zu erzielen. Häufig reicht es zum Entfernen der Gasblasen aus, ein Grobvakuum um das Substrat herum zu erzeugen, welches in einem Bereich von einem bis einigen wenigen Hundert Millibar liegen kann.

Es ist auch möglich, die Hilfssubstanz unter einem gegenüber dem Atmosphärendruck erhöhten Umgebungsdruck aufzutragen und nach dem Auftragen der Hilfssubstanz den Druck auf den Atmosphärendruck abzusenken und auf diese Weise die Gasblasen zu entfernen. Selbstverständlich sind neben dem genannten Atmosphärendruck auch beliebige andere Umgebungsdrücke denkbar. Wesentlich für das Entfernen der Gasblasen über eine Druckänderung ist, dass durch die Änderung des Umgebungsdrucks ein Bewegungsimpuls auf die Gasblasen ausgelöst wird, damit diese durch die Hilfsflüssigkeit hindurch aufsteigen und aus der Hilfssubstanz austreten. Dies kann durch Druck- und/oder Temperaturänderungen beispielsweise dadurch ausgelöst werden, dass sich die Auftriebskraft der Gasblasen durch Ausdehnen der Gasblasen erhöht und/oder das ein Siedepunkt der Hilfssubstanz unterschritten wird, wodurch das Sieden ausgelöste mechanische Arbeit den genannten Bewegungsimpuls zum Entfernen der Gasblasen auslöst oder überträgt.

Allgemein ist es bei jedem der Verfahrensschritte möglich, eine Temperatur des Substrats, der Hilfssubstanz und/oder des Beschichtungsmittels zu verändern, etwa mittels Mikrowellenbestrahlung, beispielsweise um eine Benetzung der Oberfläche des Substrats, die Diffusionsbewegungen des Beschichtungsmaterials und/oder ein Verdampfen bzw. Verdunsten der Hilfssubstanz oder des Lösungsmittels zu beschleunigen oder zu verlangsamen. Zu diesem Zweck kann auch ein Umgebungsdruck des Substrats variiert werden.

Im Folgenden werden zur weiteren Erläuterung der Erfindung einzelne Schritte eines speziellen Ausführungsbeispiels des hier vorgeschlagenen Verfahrens anhand von Figuren 1 bis 8 näher beschrieben. Es zeigen:
- Fig. 1: ein Substrat mit einer Vertiefung,
- Fig. 2: das Substrat nach Auftragen einer Schicht einer flüssigen Hilfssubstanz,
- Fig. 3: das Substrat unmittelbar nach Auftragen eines in einem Lösungsmittel gelösten Beschichtungsmaterials auf die Hilfssubstanz,
- Fig. 4: das Substrat, bei dem das Beschichtungsmaterial teilweise von dem Lösungsmittel in die Hilfssubstanz diffundiert ist,
- Fig. 5: das Substrat, nachdem ein Teil der Hilfssubstanz und des Lösungsmittels von dem Substrat abgeschleudert worden ist,
- Fig. 6: das Substrat, nachdem die Hilfssubstanz und das Lösungsmittel durch Verdampfen entfernt worden ist, wodurch sich die Beschichtung mit dem Beschichtungsmaterial ausgebildet hat,
- Fig. 7: eine Gasblase zwischen der Hilfssubstanz und der Oberfläche des Substrats innerhalb der Vertiefung des Substrats und
- Fig. 8: die Entfernung der Gasblase durch Absenkung eines Umgebungsdrucks des Substrats.

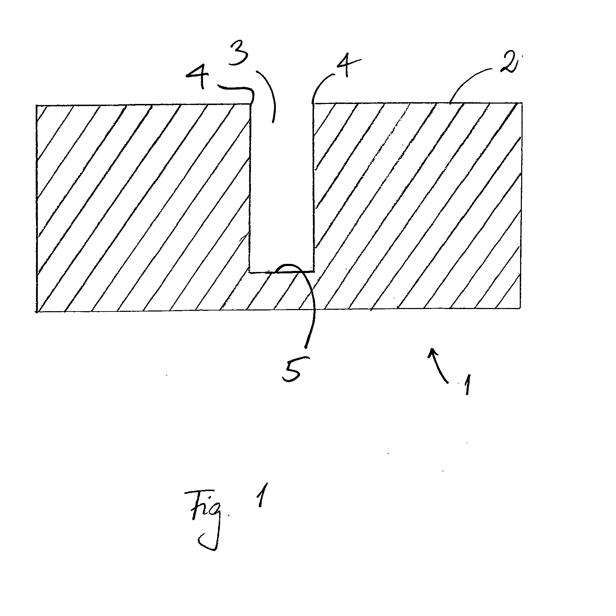

Fig. 1 zeigt eine schematische Darstellung eines Querschnitts durch ein Substrat 1 für einen Mikrochip, welches im Folgenden mit einer speziellen Ausführungsform des hier vorgeschlagenen Verfahrens beschichtet wird. Das Substrat 1 ist aus Silizium gefertigt, könnte aber genauso gut aus Glas, Kunststoff oder einem anderen geeigneten Material gefertigt sein. Eine Oberfläche 2 des Substrats 1 weist eine Vielzahl von Vertiefungen auf, von denen in dem gezeigten Querschnitt des Substrats nur eine Vertiefung 3 zu sehen ist. Die gezeigte Vertiefung 3 dient der Aufnahme eines elektrischen Leiters zur Herstellung eines elektrischen Kontakts zwischen auf der Oberfläche 2 des Substrats 1 aufgetragenen Leiterstrukturen (hier nicht dargestellt) und Leiterstrukturen auf einem weiteren, hier ebenfalls nicht dargestellten, Substrat, welcher mit dem gezeigten Substrat in einem Stapelverfahren (Wafer-Level-Packaging) nach Herstellung der Beschichtung verbunden wird.

Der gezeigte Querschnitt durch das Substrat 1 verläuft entlang eines minimalen Durchmessers der Vertiefung 3, wobei der minimale Durchmesser, wie oben beschrieben, durch den Abstand zweier (bestimmter) einander gegenüberliegender Punkte auf einem oberen Rand 4 der Vertiefung 3 gegeben ist. Der minimale Durchmesser der Vertiefung 3 beträgt in diesem Ausführungsbeispiel etwa 5 µm. Eine Tiefe der Vertiefung 3, welche als Abstand zwischen dem oberen Rand 4 und einem Boden 5 der Vertiefung 3 definiert ist, beträgt in diesem Beispiel etwa 120 µm, so dass die Tiefe also um mehr als 20mal größer ist als der minimale Durchmesser der Vertiefung.

Das Substrat 1 ist scheibenförmig ausgestaltet und ist auf einen Drehteller (hier nicht dargestellt) einer Vorrichtung zur Durchführung von Rotationsbeschichtungen ("Spin-Coater") aufgesetzt.

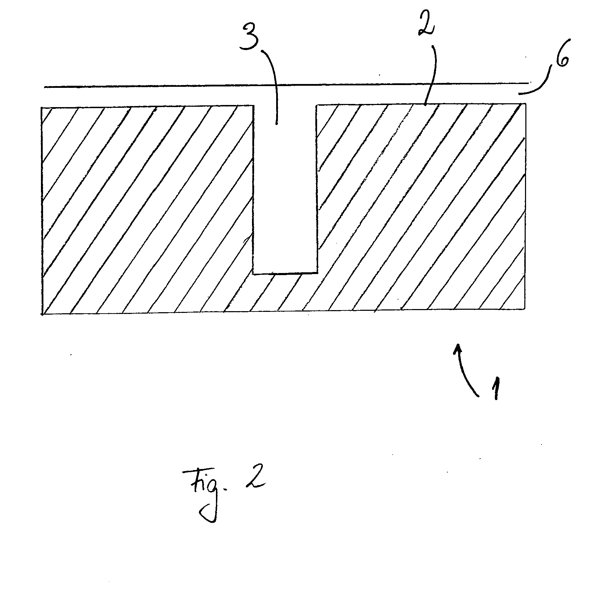

In den nachfolgenden Figuren 2 bis 8 wird das in Figur 1 dargestellte Substrat 1 in verschiedenen Stadien des hier beschriebenen Beschichtungsverfahrens gezeigt. Dabei werden für wiederkehrende Merkmale die gleichen die Bezugszeichen verwendet.

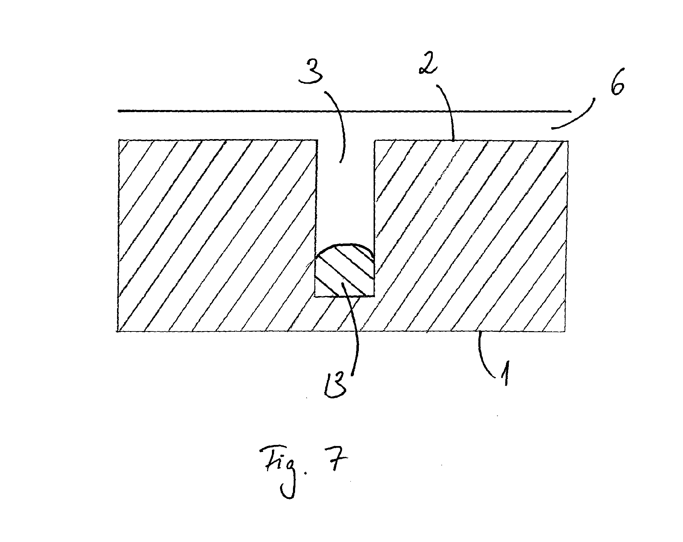

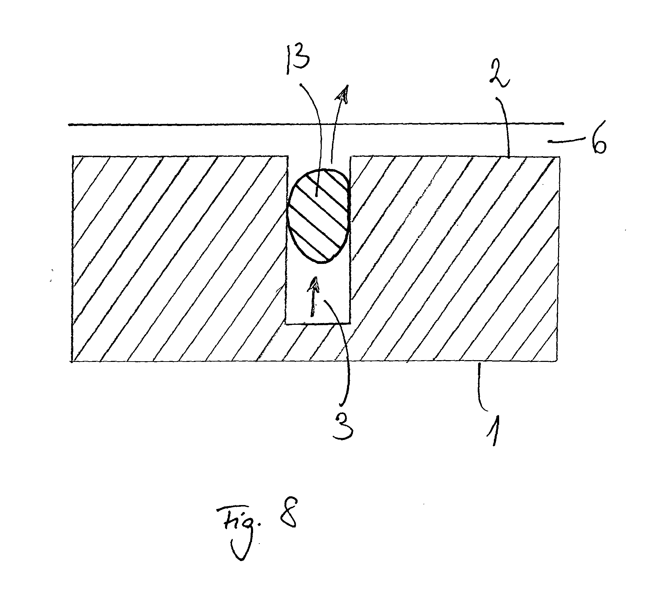

In Fig. 2 ist das in Fig. 1 gezeigte Substrat dargestellt, nachdem eine dünne Schicht einer flüssigen Hilfssubstanz auf die Oberfläche 2 des Substrats aufgetragen worden ist. Die Hilfssubstanz 6 ist in diesem Beispiel durch Ethyllactat gegeben, könnte aber genauso gut beispielsweise durch PGMEA oder eine andere der eingangs genannten Materialien gegeben sein. Entscheidend ist, dass die Hilfssubstanz die Oberfläche 2 des Substrats 1 vollständig benetzt, also bedeckt, und insbesondere auch die Vertiefung 3 möglichst vollständig ausfüllt. Für den Fall, dass Gasblasen zwischen der Hilfssubstanz 6 und der Oberfläche 2 eingeschlossen sind, können diese, vorzugsweise vor Auftragen eines Beschichtungsmaterials, entfernt werden, wie anhand von Figuren 7 und 8 weiter unten beschrieben wird.

Die im gezeigten Beispiel verwendete Hilfssubstanz 6 Ethyllactat weist eine dynamische Viskosität von nur 2,8 mPa·s auf und zeichnet sich somit durch gute Benetzungseigenschaften aus. Beim Aufgießen wird das Substrat 1 mit dem Drehteller langsam rotiert für eine bessere und schnellere Verteilung der Hilfssubstanz auf der Oberfläche 2 des Substrats 6.

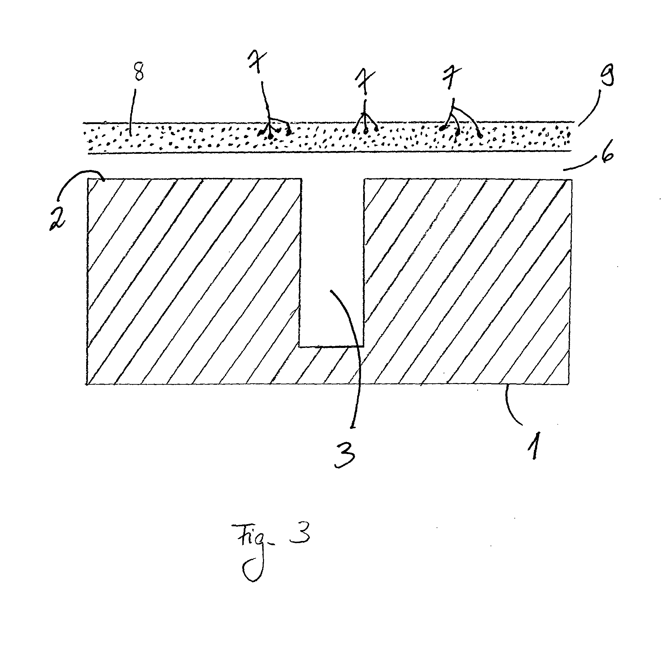

In Fig. 3 ist wiederum das in den Fign. 1 und 2 gezeigte Substrat 1 schematisch dargestellt, wobei nun auf die Schicht der Hilfssubstanz 6 ein Beschichtungsmaterial 7 aufgetragen worden ist, wobei in diesem Beispiel das Beschichtungsmaterial in einem flüssigen Lösungsmittel 8 gelöst ist und in der Fig. 3 schematisch durch einzelne Punkte dargestellt ist. Dabei soll jeder einzelne Punkt ein Molekül bzw. ein Partikel des Beschichtungsmaterials darstellen. Das Beschichtungsmaterial ist in diesem Ausführungsbeispiel durch ein Phenolharz gegeben, beispielsweise durch ELPAC 5100. Das Material des Lösungsmittels 8 ist in diesem Beispiel identisch mit der Hilfssubstanz 6, ist also ebenfalls durch Ethyllactat gegeben. Direkt nach dem Auftragen des gelösten Beschichtungsmaterials 7 auf die dünne Schicht der Hilfssubstanz 6 bildet sich zunächst eine Schicht 9 des gelösten Beschichtungsmaterials 7 auf der Schicht der Hilfssubstanz 6 aus. In diesem Beispiel wird das gelöste Beschichtungsmaterial 7, ausgehend von einem Mittelpunkt des Substrats 1, schneckenförmig auf das Substrat aufgetragen, wobei durch eine relativ langsame Rotation des Substrats 1 eine schnelle Vergleichsmäßigung des Beschichtungsmaterials 7 auf der Schicht der Hilfssubstanz 6 erzielt wird.

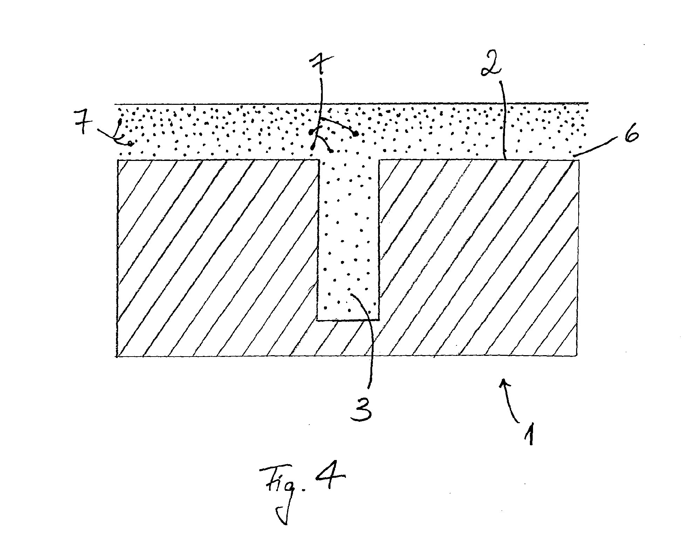

In Fig. 4 ist wiederum der Querschnitt durch das bereits in den vorangegangenen Figuren gezeigte Substrat 1 schematisch dargestellt. Im Vergleich zur Fig. 3 ist nun das Beschichtungsmaterial 7 durch Diffusion teilweise in die Hilfssubstanz 6 übergegangen. Durch die Diffusionsbewegungen der als Punkte dargestellten Moleküle des Beschichtungsmaterials 7 innerhalb der Hilfssubstanz 6 wurde das Beschichtungsmaterial 7 auch in die Vertiefung 3 hinein transportiert. Je nach Wartezeit kann eine mehr oder weniger gleichmäßige Verteilung des Beschichtungsmaterials 7 innerhalb der Hilfssubstanz 6 durch die Diffusion erzielt werden. Es ist zu erkennen, dass im hier dargestellten Zustand die Konzentration des Beschichtungsmaterials 7 innerhalb der Vertiefung 3 noch etwas geringer ist als oberhalb anderer Bereiche der Oberfläche 2 des Substrats 1. Durch weiteres Abwarten kann eine praktisch vollständige Vergleichmäßigung des Beschichtungsmaterials in der Hilfssubstanz erzielt werden.

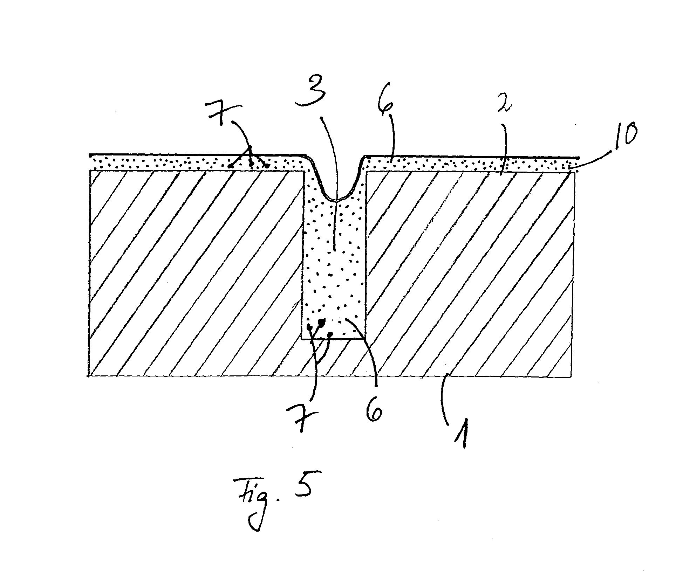

In Fig. 5 ist wiederum das in den vorausgegangenen Fign. 1 bis 4 gezeigte Substrat schematisch dargestellt. Im Vergleich zu Fig. 4 wurde nun ein großer Anteil der Hilfssubstanz 6 und des Lösungsmittels 8 durch eine Erhöhung der Rotationsfrequenz des Substrats 1 mittels des Drehtellers von der Oberfläche 2 des Substrats 1 abgeschleudert, so dass diese Flüssigkeiten 6, 8 nur noch in einer dünnen Schicht 10 auf der Oberfläche 2 sowie innerhalb der Vertiefung 3 vorhanden sind. Die Dicke der Schicht 10 könnte noch weiter reduziert werden durch eine weitere Erhöhung der Drehfrequenz und/oder durch eine länger andauernde Rotation des Substrats 1.

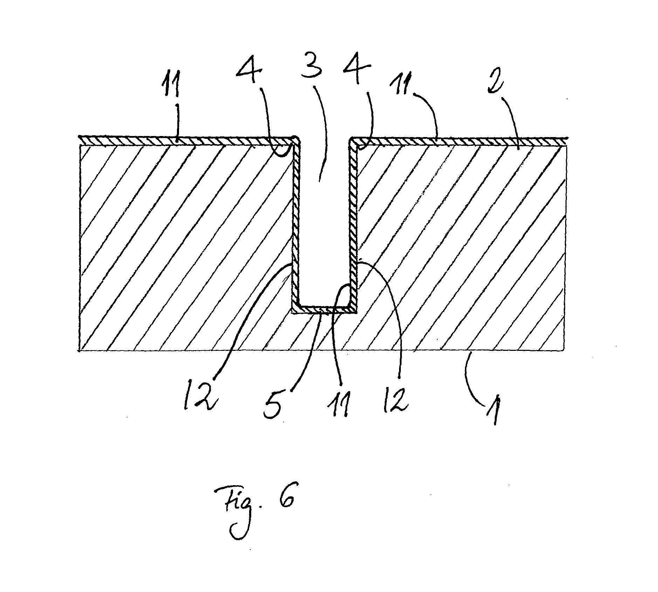

In Fig. 6 ist das in Fign. 1 bis 5 gezeigte Substrat erneut schematisch dargestellt. Gezeigt ist ein Zustand, nachdem, beispielsweise ausgehend von der in Fig. 5 gezeigten Situation, die Hilfssubstanz 6 und das Lösungsmittel 8 durch Verdunsten oder durch Verdampfen vollständig von der Oberfläche 2 des Substrats 1 entfernt worden ist, wobei zur Beschleunigung der Entfernung dieser Flüssigkeiten 6 und 8 eine Temperatur des Substrats 1 und/oder einer Umgebung des Substrats 1 mittels einer Mikrowellenbestrahlung erhöht und/oder ein Umgebungsdruck des Substrats 1 durch Anlegen eines Grobvakuums reduziert worden ist.

Durch das Entfernen der Hilfssubstanz 6 und des Lösungsmittels 8 hat sich nun eine gleichmäßige, dünne Beschichtung 11 auf der Oberfläche 2 des Substrats 1 ausgebildet. Diese Beschichtung besteht, abgesehen von möglicherweise noch bestehenden Rückständen des Lösungsmittels 8 und/oder der Hilfssubstanz 6, aus dem Beschichtungsmaterial 7. Insbesondere wurden auch der Rand 4, der Boden 5 sowie Seitenwände 12 der Vertiefung mit einer sehr gleichmäßigen Dicke mit dem Beschichtungsmaterial 7 beschichtet. Auf diese Weise können insbesondere Kurzschlüsse im Bereich des Randes zuverlässig vermieden werden. Die Dicke der Schicht 11 beträgt in diesem Beispiel etwa 2 µm.

Anhand der Fign. 7 bis 8 wird die Entfernung einer Gasblase 13 beschrieben, welche zwischen der Oberfläche 2 eines Substrats 1 und der auf diese Oberfläche 2 aufgetragene Hilfssubstanz 6 innerhalb einer Vertiefung 3 in dieser Oberfläche 2 unmittelbar nach Auftragen der Hilfsflüssigkeit 6 auf die Oberfläche 2 des Substrats 1 eingeschlossen ist. Durch Anlegen eines Grobvakuums für wenige Sekunden direkt nach Auftragen der Hilfssubstanz 6, dehnt sich die Gasblase etwas aus und erhält dadurch einen etwas größeren Auftrieb, so dass ein Bewegungsimpuls auf die Gasblase 13 übertragen wird. Es kann hierdurch aber auch ein Siedepunkt der Hilfssubstanz 6 unterschritten werden, so dass durch das einsetzende Sieden der Hilfssubstanz 6 der Bewegungsimpuls auf die Gasblase 13 übertragen wird.

Daraufhin bewegt sich die Gasblase 13 nun, wie in Fig. 8 dargestellt, nach oben und aus der Vertiefung 3 hinaus bis sie schließlich die Oberfläche 2 des Substrats sowie die Hilfssubstanz 6 vollständig verlassen hat und die in Fig. 1 dargestellte Situation ohne Gasblase 13 vorliegt. Anschließend kann die Beschichtung, wie in den Fign. 2 bis 6 dargestellt, fortgesetzt werden.

Insbesondere kann unmittelbar nach der Entfernung der Gasblase 13 der Umgebungsdruck des Substrats 1 wieder auf seinen Ausgangswert, beispielsweise auf den normalen Atmosphärendruck, angehoben werden. Zur Entfernung der Gasblasen ist in der Regel eine nur kurzzeitige Absenkung des Drucks, etwa um wenige Sekunden, beispielsweise 1 bis 2 s, ausreichend.

### Bezugszeichenliste

- 1: Substrat
- 2: Oberfläche
- 3: Vertiefung
- 4: Oberer Rand der Vertiefung
- 5: Boden der Vertiefung
- 6: Hilfssubstanz
- 7: Beschichtungsmaterial
- 8: Lösungsmittel
- 9: Schicht des gelösten Beschichtungsmittels
- 10: Schicht von Lösungsmittel und Hilfssubstanz
- 11: Beschichtung mit Beschichtungsmaterial
- 12: Seitenwände der Vertiefung
- 13: Gasblase

## Patentansprüche

1. Verfahren zum Herstellen einer Beschichtung (11) einer Oberfläche (2) eines mindestens eine Vertiefung (3) aufweisenden Substrats (1) mit einem Beschichtungsmaterial (7),
**dadurch gekennzeichnet,**
- **dass** auf die Oberfläche (2) des Substrats (1) zunächst eine flüssige Hilfssubstanz (6) aufgetragen wird und die mindestens eine Vertiefung (3) in der Oberfläche (2) des Substrats (1) mit der flüssigen Hilfssubstanz (6) ausgefüllt wird,
- wobei anschließend das Beschichtungsmaterial (7) auf die Hilfssubstanz (6) auf dem Substrat (1) aufgetragen wird,
- wobei zumindest ein Teil des Beschichtungsmaterials (7) in die mindestens eine mit der flüssigen Hilfssubstanz (6) ausgefüllte Vertiefung (3) in der Oberfläche (2) transportiert wird durch Diffusion des Beschichtungsmaterials (7) in der flüssigen Hilfssubstanz (6),
- wobei anschließend die Hilfssubstanz (6) von der Oberfläche (2) des Substrats (1) entfernt wird, wobei das Beschichtungsmaterial (7) zumindest teilweise auf der Oberfläche (2) des Substrats (1) zurückbleibt und die Beschichtung (11) der Oberfläche (2) einschließlich der mindestens einen Vertiefung (3) mit dem Beschichtungsmaterial (7) ausbildet.

2. Verfahren nach Anspruch 1, **dadurch gekennzeichnet, dass** zwischen der flüssigen Hilfssubstanz (6) und der Oberfläche (2) des Substrats (1) eingeschlossene Gasblasen (13) entfernt werden.

3. Verfahren nach Anspruch 2, **dadurch gekennzeichnet, dass** zum Entfernen der Gasblasen (13) zwischen der flüssigen Hilfssubstanz (6) und der Oberfläche (2) des Substrats (1) eine Bewegung der Gasblasen (13) von der Oberfläche (2) des Substrats (1) weg und durch die flüssige Hilfssubstanz (6) hindurch ausgelöst wird durch Anheben und/oder Absenken eines Umgebungsdrucks einer an die Hilfssubstanz (6) angrenzenden Umgebung des Substrats.

4. Verfahren nach Anspruch 3, **dadurch gekennzeichnet, dass** das Absenken und/oder das Anheben des Umgebungsdrucks noch vor dem Auftragen des Beschichtungsmaterials (7) auf die Hilfssubstanz (6) durchgeführt wird.

5. Verfahren nach einem der Ansprüche 3 oder 4, **dadurch gekennzeichnet, dass** der Umgebungsdruck zum Entfernen der Gasblasen (13) nur kurzzeitig abgesenkt wird und unmittelbar nach Entfernen der Gasblasen (13) wieder angehoben wird.

6. Verfahren nach einem der vorangehenden Ansprüche, **dadurch gekennzeichnet, dass** das Beschichtungsmaterial (7) ein Photolack, ein Polymer, ein Prepolymer und/oder ein Monomer enthält.

7. Verfahren nach einem der vorangehenden Ansprüche, **dadurch gekennzeichnet**, **dadurch gekennzeichnet, dass** die Hilfssubstanz (6) Ethyllactat und/oder Propylenglykolmonomethylacetat (PGMEA) enthält.

8. Verfahren nach einem der vorangehenden Ansprüche, **dadurch gekennzeichnet, dass** die auf die Oberfläche (2) des Substrats (1) aufgetragene Hilfssubstanz (6) eine Viskosität von maximal 5 mPa·s aufweist, vorzugsweise maximal 3 mPa·s.

9. Verfahren nach einem der vorangehenden Ansprüche, **dadurch gekennzeichnet, dass** die Hilfssubstanz (6) durch Trocknen und/oder Verdampfen von der Oberfläche (2) des Substrats (1) vollständig entfernt wird.

10. Verfahren nach einem der vorangehenden Ansprüche, **dadurch gekennzeichnet, dass** in einem Zwischenschritt die Hilfssubstanz (6) durch Abschleudern bis auf Anteile der Hilfssubstanz (6) innerhalb der mindestens einen Vertiefung (3) von der Oberfläche (2) des Substrats (1) entfernt wird.

11. Verfahren nach einem der vorangehenden Ansprüche, **dadurch gekennzeichnet, dass** das Substrat (1) unter Verwendung einer Vorrichtung zur Durchführung von Rotationsbeschichtungen rotiert wird zum Verteilen der Hilfssubstanz (6) und/oder des Beschichtungsmaterials (7) auf der Oberfläche (2) des Substrats (1) und/oder zum Abschleudern der Hilfssubstanz (6) und/oder des Beschichtungsmaterial (7) von der Oberfläche (2) des Substrats.

12. Verfahren nach einem der vorangehenden Ansprüche, **dadurch gekennzeichnet, dass** ein minimaler Durchmesser der mindestens einen Vertiefung (3) weniger als 200 µm beträgt, vorzugsweise weniger als 20 µm.

13. Verfahren nach einem der vorangehenden Ansprüche, **dadurch gekennzeichnet, dass** eine Tiefe der mindestens einen Vertiefung (3) mehr als 20 µm beträgt, vorzugsweise mehr als 100 µm.

14. Verfahren nach einem der vorangehenden Ansprüche, **dadurch gekennzeichnet, dass** eine Tiefe der mindestens einen Vertiefung (3) mindestens zehnmal so groß ist wie ein minimaler Durchmesser der Vertiefung, vorzugsweise mindestens zwanzigmal so groß.

15. Verfahren nach einem der vorangehenden Ansprüche, **dadurch gekennzeichnet, dass** die mindestens eine Vertiefung (3) eine Durchtrittsöffnung durch das Substrat (1) hindurch, insbesondere zur Herstellung einer Durchkontaktierung durch das Substrat, ein Through-Silicon-Via, ein thermisches Via, ein Wärmespreizer oder ein in das Substrat (1) eingearbeiteter mikrofluidischer Kanal ist.

## Claims

1. A method for producing a coating (11) of a surface (2) of a substrate (1) having at least one recess (3) with a coating material (7),
**characterised in that**
- first of all a liquid auxiliary substance (6) is applied to the surface (2) of the substrate (1) and the at least one recess (3) in the surface (2) of the substrate (1) is filled in with the liquid auxiliary substance (6),
- with the coating material (7) then being applied to the auxiliary substance (6) on the substrate (1),
- with at least part of the coating material (7) being transported into the at least one recess (3) in the surface (2) which is filled with the liquid auxiliary substance (6) by diffusion of the coating material (7) in the liquid auxiliary substance (6),
- with the auxiliary substance (6) then being removed from the surface (2) of the substrate (1), the coating material (7) remaining behind at least in part on the surface (2) of the substrate (1) and forming the coating (11) of the surface (2) including the at least one recess (3) with the coating material (7).

2. A method according to Claim 1, **characterised in that** gas bubbles (13) included between the liquid auxiliary substance (6) and the surface (2) of the substrate (1) are removed.

3. A method according to Claim 2, **characterised in that** for removing the gas bubbles (13) between the liquid auxiliary substance (6) and the surface (2) of the substrate (1) a movement of the gas bubbles (13) away from the surface (2) of the substrate (1) and through the liquid auxiliary substance (6) is triggered by raising and/or lowering an ambient pressure of the surroundings of the substrate which adjoin the auxiliary substance (6).

4. A method according to Claim 3, **characterised in that** the lowering and/or the raising of the ambient pressure is carried out even before the application of the coating material (7) to the auxiliary substance (6).

5. A method according to one of Claims 3 or 4, **characterised in that** the ambient pressure is lowered only briefly in order to remove the gas bubbles (13) and is raised again directly after removing the gas bubbles (13).

6. A method according to one of the preceding claims, **characterised in that** the coating material (7) contains a photoresist, a polymer, a prepolymer and/or a monomer.

7. A method according to one of the preceding claims, **characterised in that characterised in that** the auxiliary substance (6) contains ethyl lactate and/or propylene glycol monomethyl acetate (PGMEA).

8. A method according to one of the preceding claims, **characterised in that** the auxiliary substance (6) which is applied to the surface (2) of the substrate (1) has a viscosity of at most 5 mPa·s, preferably at most 3 mPa·s.

9. A method according to one of the preceding claims, **characterised in that** the auxiliary substance (6) is removed completely from the surface (2) of the substrate (1) by drying and/or evaporating.

10. A method according to one of the preceding claims, **characterised in that** in an intermediate step the auxiliary substance (6) is removed from the surface (2) of the substrate (1) by centrifuging off down to portions of the auxiliary substance (6) within the at least one recess (3).

11. A method according to one of the preceding claims, **characterised in that** the substrate (1) is spun using a device for carrying out spin coatings in order to distribute the auxiliary substance (6) and/or the coating material (7) on the surface (2) of the substrate (1) and/or for centrifuging off the auxiliary substance (6) and/or the coating material (7) from the surface (2) of the substrate.

12. A method according to one of the preceding claims, **characterised in that** a minimum diameter of the at least one recess (3) is less than 200 µm, preferably less than 20 µm.

13. A method according to one of the preceding claims, **characterised in that** a depth of the at least one recess (3) is more than 20 µm, preferably more than 100 µm.

14. A method according to one of the preceding claims, **characterised in that** a depth of the at least one recess (3) is at least ten times as great as a minimum diameter of the recess, preferably at least twenty times as great.

15. A method according to one of the preceding claims, **characterised in that** the at least one recess (3) is a passage opening through the substrate (1), in particular for the production of a through-connection through the substrate, a through-silicone via, a thermal via, a heat spreader or a microfluidic channel machined into the substrate (1).

## Revendications

1. Procédé pour réaliser, avec un matériau de revêtement (7), un revêtement (11), d'une surface (2) d'un substrat (1) comprenant au moins un renfoncement (3), **caractérisé en ce que**
- on applique d'abord une substance auxiliaire liquide (6) sur la surface (2) du substrat (1), et on remplit au moins un renfoncement (3) aménagé dans la surface (2) du substrat (1), avec la substance auxiliaire liquide (6)
- puis on applique le matériau de revêtement (7) sur la substance auxiliaire (6) se trouvant sur le substrat (1),
- au moins une partie du matériau de revêtement (7) étant transportée dans le ou les renfoncements (3), aménagé(s) dans la surface (2), rempli(s) de la substance auxiliaire liquide (6), par diffusion du matériau de revêtement (7) dans la substance auxiliaire liquide (6),
- puis on élimine la substance auxiliaire (6) de la surface (2) du substrat (1), le matériau de revêtement (7) restant au moins partiellement sur la surface (2) du substrat (1) et constituant le revêtement (11), par le matériau de revêtement (7), de la surface (2), y compris du ou des renfoncements (3).

2. Procédé selon la revendication 1, **caractérisé en ce qu'**on élimine les bulles de gaz (13) incluses entre la surface auxiliaire liquide (6) et la surface (2) du substrat (1).

3. Procédé selon la revendication 2, **caractérisé en ce que**, pour éliminer les bulles de gaz (13) entre la substance auxiliaire liquide (6) et la surface (2) du substrat (1), on déclenche un mouvement des bulles de gaz (13), à partir de la surface (2) du substrat (1), et à travers la substance auxiliaire liquide (6), par augmentation et/ou diminution d'une pression ambiante avoisinant la substance auxiliaire (6), du substrat.

4. Procédé selon la revendication 3, **caractérisé en ce que** la diminution et/ou l'augmentation de la pression ambiante sont mises en oeuvre encore avant application du matériau de revêtement (7) sur la substance auxiliaire (6).

5. Procédé selon l'une des revendications 3 ou 4, **caractérisé en ce que** la pression ambiante, pour éliminer les bulles de gaz (13), n'est diminuée que pendant un bref laps de temps, puis est immédiatement ré-augmentée après élimination des bulles de gaz (13).

6. Procédé selon l'une des revendications précédentes, **caractérisé en ce que** le matériau de revêtement (7) contient un vernis photosensible, un polymère, un prépolymère et/ou un monomère.

7. Procédé selon l'une des revendications précédentes, **caractérisé en ce que** la substance auxiliaire (6) contient du lactate d'éthyle et/ou de l'acétate de l'éther monométhylique du propylèneglycol (PGMEA).

8. Procédé selon l'une des revendications précédentes, **caractérisé en ce que** la substance auxiliaire (6) appliquée sur la surface (2) du substrat (1) présente une viscosité au maximum de 5 mPa.s, de préférence au maximum de 3 mPa.s.

9. Procédé selon l'une des revendications précédentes, **caractérisé en ce que** la substance auxiliaire (6) est entièrement éliminée par séchage et/ou évaporation de la surface (2) du substrat (1).

10. Procédé selon l'une des revendications précédentes, **caractérisé en ce que**, dans une étape intermédiaire, on élimine de la surface (2) du substrat (1) la substance auxiliaire (6) par projection centrifuge jusqu'à certaines parties de la substance auxiliaire (6) à l'intérieur du ou des renfoncements (3).

11. Procédé selon l'une des revendications précédentes, **caractérisé en ce que** le substrat (1) est mis en rotation par utilisation d'un dispositif pour la mise en oeuvre de revêtements à la tournette, pour répartir la substance auxiliaire (6) et/ou le matériau de revêtement (7) sur la surface (2) du substrat (1) et/ou pour éliminer par projection centrifuge, de la surface (2) du substrat, la substance auxiliaire (6) et/ou le matériau de revêtement (7).

12. Procédé selon l'une des revendications précédentes, **caractérisé en ce qu'**un diamètre minimal du ou des renfoncements (3) est inférieur à 200 µm, de préférence inférieur à 20 µm.

13. Procédé selon l'une des revendications précédentes, **caractérisé en ce qu'**une profondeur du ou des renfoncements (3) est supérieure à 20 µm, de préférence supérieure à 100 µm.

14. Procédé selon l'une des revendications précédentes, **caractérisé en ce qu'**une profondeur du ou des renfoncements (3) est au moins dix fois plus grande qu'un diamètre minimal du renfoncement, de préférence au moins vingt fois plus grande.

15. Procédé selon l'une des revendications précédentes, **caractérisé en ce que** le ou les renfoncements (3) sont des ouvertures de passage à travers le substrat (1), en particulier pour réaliser un trou de liaison à travers le substrat, un trou de liaison à travers le silicium, un trou de liaison thermique, un dissipateur thermique ou un canal microfluidique incorporé dans le substrat (1).
